# FASCICULE DE BREVET EUROPEEN

(11) **EP 3 671 814 B1**
(45) Date de publication et mention de la délivrance du brevet: **12.01.2022**
(21) Numéro de dépôt: 19218744.1
(22) Date de dépôt: 20.12.2019
(51) Int. Cl.: H01L 21/311, H01L 21/3115

(54) **PROCÉDÉ DE GRAVURE D'UNE COUCHE DIÉLECTRIQUE**
VERFAHREN ZUM ÄTZEN EINER DIELEKTRISCHEN SCHICHT
METHOD FOR ETCHING A DIELECTRIC LAYER

(30) Priorité: 21.12.2018 FR 1874062
(43) Date de publication de la demande: 24.06.2020
(73) Titulaire: Commissariat à l'Energie Atomique et aux Energies Alternatives, 75015 Paris (FR)
(72) Inventeur: POSSEME, Nicolas, 38054 GRENOBLE CEDEX 09 (FR); LE ROUX, Frédéric, 38054 GRENOBLE CEDEX 09 (FR)
(74) Mandataire: Hautier, Nicolas

(56) Documents cités:
- EP-A1- 2 750 170
- CN-A- 106 504 986
- US-A1- 2005 236 365

## Description

La présente invention concerne en général l'intégration de couches à base de nitrure de gallium (GaN) au sein de dispositifs micro-électroniques. Elle trouvera pour application avantageuse la réalisation de dispositifs tels que des transistors ou des diodes intégrant une plusieurs couches comprenant du nitrure de gallium (GaN).

### ÉTAT DE LA TECHNIQUE

La chasse au gaspillage énergétique et l'augmentation des besoins poussent les fabricants de dispositifs microélectroniques à améliorer les rendements et les performances de leurs systèmes de conversion de l'énergie électrique. Actuellement, les circuits de conversion sont fabriqués à base de silicium et de nombreuses recherches ont été menées pour faire évoluer les architectures dans le but de gagner en rendement et en conductivité. Néanmoins, ces dispositifs connus arrivent aux limites théoriques du silicium et de nouvelles solutions doivent être développées.

Grâce à ses propriétés électriques permettant la formation d'un gaz d'électron bi-dimensionnel, l'hétérostructure AlGaN/GaN, formée d'une couche de nitrure d'aluminium-galium sur une couche de nitrure de galium, présente de bonnes perspectives pour le développement de l'électronique de puissance. Il concurrence le Si et le SiC en termes de taille de dispositif, de tenue en tension, de mobilité de porteurs ainsi que de résistance en série.

Néanmoins, l'utilisation pratique de cette hétérostructure AlGaN/GaN par exemple dans un transistor ou une diode pose des problématiques fortes qu'il convient de résoudre afin d'exploiter toutes les performances de ces matériaux à base de GaN. Il a été notamment identifié que les étapes de gravure, pour les structurations des dispositifs, sont critiques et dégradent les propriétés électriques du canal.

Ces étapes de gravure concernent notamment l'ouverture d'une couche de passivation surmontant l'hétérostructure AlGaN/GaN afin de former les contacts d'une diode ou de former la grille ou les contacts pour les transistors, par exemple des transistors HEMT (acronyme anglais de « High Electron Mobility Transistor »).

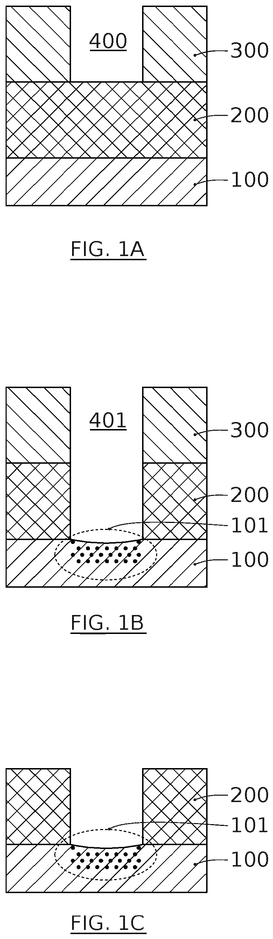

Les figures 1A à 1C illustrent les étapes des solutions connues ainsi que les inconvénients induits par ces solutions.

La figure 1A illustre un empilement comprenant successivement une couche d'AIGaN 100, une couche de passivation 200 en SiN ou SiO2, et un masque de résine 300. Le masque de résine 300 présente une ouverture 400.

Comme illustré en figure 1B, la couche de passivation 200 est ensuite ouverte à travers le masque de résine 300 pour former un masque dur. Cette ouverture 401 de la couche de passivation 200 est effectuée par une gravure plasma basée sur une chimie fluorocarbonée (FC).

Ces procédés conduisent à incorporer des ions fluorés dans la couche d'AIGaN 100. La couche d'AIGaN 100 présente alors une zone 101 dont les caractéristiques électriques sont modifiées et dégradées.

Par ailleurs, ces procédés sont sensibles à la sur-gravure de la couche de passivation 200. Comme illustré en figure 1B, la gravure complète de la couche de passivation 200 conduit bien souvent à consommer de manière involontaire la surface de la couche d'AIGaN 100.

En outre, ces procédés connus sont sensibles aux effets de charge occasionnés par la consommation des espèces neutres réactives, conduisant ainsi à une diminution de leur concentration dans la phase gazeuse (« macroloading ») ou localement à l'échelle de la structure microscopique (« microloading »). Ces phénomènes conduisent donc à des non-uniformités de gravure à l'échelle macroscopique ou microscopique. Ces phénomènes conduisent à de fortes hétérogénéités de gravure et d'implantation au sein d'une même plaque, en fonction de la densité des motifs.

Tous ces inconvénients conduisent à dégrader la couche d'AIGaN 100 et à réduire les performances du dispositif.

US 2005/236365 A1 divulgue un procédé de gravure d'une couche diélectrique SiNx située sur une couche GaN.

Il existe donc un besoin consistant à proposer une solution pour retirer une couche de passivation surmontant une couche d'AIGaN, tout en limitant, voire en supprimant les défauts générés par les solutions connues.

Tel est un objectif de la présente invention.

### RÉSUMÉ

Pour atteindre cet objectif, la présente invention prévoit un procédé de gravure d'une couche diélectrique située sur au moins une couche à base de nitrure de gallium (GaN), la couche diélectrique étant formée d'un matériau à base de l'un parmi le SixNy et le SixOy avec x et y entiers non nuls, le procédé comprenant au moins les étapes suivantes:
- première gravure de la couche diélectrique sur une partie seulement d'une épaisseur e₂₀₀ de la couche diélectrique pour définir dans la couche diélectrique au moins une ouverture partielle et au moins une portion résiduelle située au droit de l'ouverture et présentant une épaisseur e₂₀₂ ;
- implantation d'ions au droit de l'ouverture partielle sur une épaisseur supérieure à l'épaisseur e₂₀₂de sorte à :
   ∘ modifier le matériau de la couche diélectrique au droit de l'ouverture sur toute l'épaisseur e₂₀₂ de la portion résiduelle ;
   ∘ modifier le matériau de la couche à base de GaN sur une portion de la couche à base de GaN située au droit de l'ouverture, lesdits ions étant pris à base d'hydrogène (H) et/ou d'hélium (He);
- retrait de la portion résiduelle à l'aide d'une deuxième gravure, la deuxième gravure étant sélective du matériau modifié de la couche diélectrique vis-à-vis du matériau non modifié de la couche diélectrique et vis-à-vis du matériau modifié de la couche à base de GaN;
- recuit au moins de la couche à base de GaN pendant une durée supérieure à D1 et une température comprise entre T1 et T2, avec D1 = 30s, T1 = 300°C et T2 = 900°C, de préférence T2 = 600°C.

Ainsi, après une phase de gravure partielle, ce procédé prévoit d'implanter des ions à base d'hydrogène ou d'hélium dans toute l'épaisseur résiduelle et au-delà de l'interface entre la couche diélectrique et la couche à base de GaN.

L'implantation des ions à base d'hydrogène ou d'hélium permet d'augmenter très significativement la sélectivité de la gravure de la couche diélectrique vis-à-vis des portions non modifiées de la couche diélectrique et vis-à-vis de la couche à base de GaN.

L'implantation des ions réalisée au-delà de l'interface entre la couche diélectrique et la couche à base de GaN permet de s'assurer que toute la couche diélectrique est effectivement implantée. On peut ainsi aisément retirer toute la couche diélectrique sans risque que des résidus de cette couche subsistent à la surface de la couche à base de GaN. Ainsi, le procédé proposé permet de retirer toute la couche diélectrique située au droit de l'ouverture tout en relâchant les contraintes par rapport à des procédés différents qui nécessiteraient de stopper l'implantation de la couche diélectrique avant la couche à base de GaN.

Par ailleurs, alors que la couche à base de GaN se trouve fortement détériorée par l'implantation, le recuit, avec les paramètres mentionnés ci-dessus, a permis d'obtenir un matériau à base de GaN dont les propriétés sont proches de celles que ce matériau présentait avant implantation. Typiquement, les propriétés électriques de la zone du matériau à base de GaN implantée puis soumise au recuit sont identiques à, ou très proches de, celles de ce même matériau après croissance par épitaxie.

On notera que ce type de recuit n'a pas donné de résultats satisfaisants lorsque la gravure pour ouvrir la couche diélectrique est basée sur une chimie fluorocarbonée.

Par ailleurs, on notera que si l'on utilise un masque de résine pour ouvrir la couche diélectrique, on peut retirer ce masque de résine avant de retirer l'épaisseur résiduelle de la couche diélectrique. Ainsi, lors de l'étape de gravure (habituellement désigné par le vocable anglais de stripping) de la résine, typiquement à l'aide d'un plasma à base d'oxygène, la couche à base de GaN se trouve protégée par cette épaisseur résiduelle. On évite ainsi l'oxydation de la couche à base de GaN située au droit de l'ouverture.

Au contraire, dans les procédés connus et illustrés en figure 1A à 1C le retrait du masque de résine 300 conduit à oxyder la surface découverte de la couche d'AIGaN 100 dans la zone 101.

Le procédé proposé offre donc des avantages significatifs par rapport aux procédés connus et conduit à améliorer considérablement les performances des dispositifs à base de GaN. Par ailleurs ce dispositif est fiable, aisément reproductible et peu coûteux.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 1C illustrent les étapes principales des procédés connus.
La figure 2 illustre, sous forme d'un ordinogramme, les étapes principales d'un procédé selon un mode de réalisation de la présente invention.
Les figures 3A à 3F illustrent de manière schématique les étapes principales d'un procédé selon un premier mode de réalisation de la présente invention.
Les figures 4A à 4F illustrent de manière schématique les étapes principales d'un procédé selon un deuxième mode de réalisation de la présente invention.
Les figures 5A à 5g illustrent de manière schématique les étapes principales d'un procédé selon un troisième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

Selon un exemple, la première gravure est basée sur une chimie fluorocarbonée.

Selon un exemple, l'épaisseur e202 de la portion résiduelle est comprise entre 10 nm et 30 nm, et de préférence entre 5 nm et 30 nm. Une valeur limite pour l'implantation plasma est de 30 nm. Une profondeur d'implantation supérieure peut conduire à augmenter la tension de polarisation ce qui risque de consommer une partie de la portion résiduelle par pulvérisation.

Selon un exemple de réalisation, l'épaisseur e202 de la portion résiduelle est supérieure à 4nm et de préférence supérieure à 10 nm.

Cela permet de ne pas endommager la couche sous-jacente lors de la première gravure de la couche diélectrique. En effet, lors de cette première gravure, on est sûr de ne pas atteindre la couche sous-jacente.

Selon un exemple, ladite portion de la couche à base de GaN située au droit de l'ouverture et dont le matériau est modifié lors de l'implantation présente une épaisseur e102 supérieure à 4 nm, e102 étant de préférence comprise entre 5 nm et 30 nm.

Selon un exemple, l'implantation est effectuée à l'aide d'un plasma.

Alternativement l'implantation est effectuée par des implanteurs.

Les ions implantés sont de préférence pris parmi les ions suivants: H, H+, H2+, H3+, He+.

Selon un exemple, le recuit est réalisé à pression ambiante (P atmosphère). Selon un exemple, la couche diélectrique est située directement au contact de la couche à base de GaN.

Selon un exemple, la couche à base de GaN est faite en un matériau à base de nitrure de gallium (GaN).

Selon un autre exemple, la couche à base de GaN est en AIGaN, la couche à base de GaN en AIGaN surmontant une couche de GaN.

Selon un exemple, la couche diélectrique est en SixNy, de préférence en nitrure de silicium (SiN), et la couche diélectrique est déposée à une température supérieure ou égale à 500°C. Selon un autre exemple, la couche diélectrique est en SixOy, de préférence en oxyde de silicium (SiO2), et la couche diélectrique est déposée à une température supérieure ou égale à 500°C.

Selon un exemple, le procédé selon l'invention comprend les étapes suivantes préalables à l'étape de première gravure :
- dépôt d'une couche de résine surmontant la couche diélectrique,
- ouverture de la couche de résine pour former un masque de résine,
- ladite première gravure de la couche diélectrique pour définir dans la couche diélectrique au moins une ouverture partielle étant effectuée à travers ledit masque de résine.

Selon un exemple, après ladite implantation et avant le retrait de la portion résiduelle, un retrait du masque de résine, de préférence, le retrait du masque de résine est effectué au moins en partie par un plasma à base d'oxygène.

Avantageusement, la portion résiduelle protège la couche à base de GaN lors du retrait du masque de résine. On évite ainsi que la couche à base de GaN subisse une oxydation de surface.

Selon un exemple, le procédé selon l'invention comprend après ladite première gravure de la couche diélectrique et avant ladite implantation, au moins la formation d'un film de protection sur le masque de résine.

Selon un exemple, le film de protection est formé par dépôt d'un matériau polymère.

Selon un exemple, le film de protection est formé par un dépôt conforme à base d'une chimie fluorocarbonée, le film de protection étant en Cx₀Hy₀Fz₀, avec x₀, y₀, et z₀ des entiers, de préférence des entiers non nuls.

Selon un exemple, ladite implantation est effectuée selon une direction principale et par mise en présence de la couche diélectrique avec un plasma dans lequel on introduit du Cx1Hy1 où x1 est la proportion de carbone (C) et y1 est la proportion d'hydrogène (H) et comprenant des ions plus lourds que l'hydrogène; les conditions du plasma, en particulier la concentration en Cx1Hy1, l'énergie des ions et la direction principale d'implantation étant choisies de manière à ce que :
- le plasma crée un bombardement d'ions à base d'hydrogène (H, H+, H2+, H3+ etc.) provenant du Cx1Hy1 selon la direction principale,
- des espèces chimiques du plasma contenant du carbone provenant du CxHy forment un film de protection carboné notamment sur des surfaces parallèles à la direction du bombardement ;
- le plasma crée un bombardement des ions plus lourds que l'hydrogène qui empêche auxdites espèces chimiques du plasma contenant du carbone et provenant du Cx1Hy1 de former un film de protection carboné notamment sur les surfaces du masque de résine qui sont perpendiculaires à la direction principale du bombardement.

Selon un exemple, au moins deux des étapes suivantes et de préférence toutes les étapes suivantes sont effectuées dans un même réacteur, de préférence un réacteur plasma:
- ladite première gravure,
- ladite implantation,
- ladite deuxième gravure.
- Cela permet de raccourcir les cycles de production et d'abaisser considérablement les coûts de réalisation.

On entend par un substrat, un film, une couche, « à base » d'un matériau A, un substrat, un film, une couche comprenant ce matériau A uniquement ou ce matériau A et éventuellement d'autres matériaux.

Ainsi, dans la présente description, une couche à base de GaN peut être une couche constituée exclusivement de GaN ou une couche comportant du GaN et d'autres éléments. Typiquement il peut s'agir d'une couche d'AIGaN, d'InGaN ou d'AlInGaN.

Selon un exemple, la couche à base de GaN comprend du GaN et un ou plusieurs éléments de la colonne III ou de la colonne V du tableau périodique des éléments.

Selon un exemple la couche est de l'AlGaN ou de l'AlGaN dopé. Il peut aussi s'agir de GaN ou de GaN dopé. Le dopage du GaN ou de l'AlGaN peut être réalisé avec l'une au moins des espèces suivantes : Mg, Si, P, O, Ca, C.

De même, dans la présente description, un matériau à base de l'un parmi le SixNy et le SixOy avec x et y entiers peut, par exemple, être l'un des matériaux suivants : SiN, Si3N4, SiO2, SiCO, SiOCH, SiOCN, SiCBN.

Le mot « diélectrique » qualifie un matériau dont la conductivité électrique est suffisamment faible dans l'application donnée pour servir d'isolant électrique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents. Ainsi, une couche à base de GaN peut comprendre un empilement de couches à base de GaN. Une couche à base de GaN peut ainsi comprendre une couche d'AIGaN située sur, de préférence directement au contact de, une couche faite de GaN.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Dans le cadre de la présente invention, on qualifie de résine un matériau organique ou organo-minéral pouvant être mis en forme par une exposition à un faisceau d'électrons, de photons ou de rayons X ou mécaniquement.

On peut citer à titre d'exemple des résines classiquement employées en microélectronique, des résines à base de polystyrène (PS), de méthacrylate (par exemple le Polymethyl methacrylate PMMA), d'Hydrosilsesquioxane (HSQ), de polyhydroxystyrène (PHS) etc. L'intérêt d'utiliser une résine est qu'il est facile d'en déposer une épaisseur importante, de plusieurs centaines de nanomètres à plusieurs microns.

Il est précisé que dans le cadre de la présente invention, l'épaisseur d'une couche ou du substrat se mesure selon une direction perpendiculaire à la surface selon laquelle cette couche ou ce substrat présente son extension maximale.

Sur les figures, l'épaisseur est prise selon la verticale.

De même lorsqu'on indique qu'un élément est situé au droit ou à l'aplomb d'un autre élément, cela signifie que ces deux éléments sont situés tous deux sur une même ligne perpendiculaire au plan principal du substrat, soit sur une même ligne orientée verticalement sur les figures

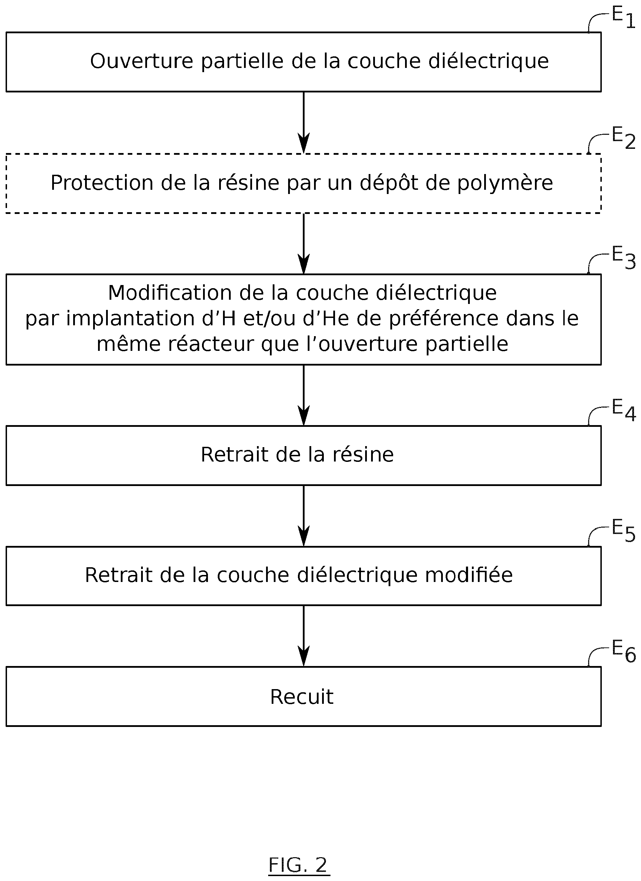

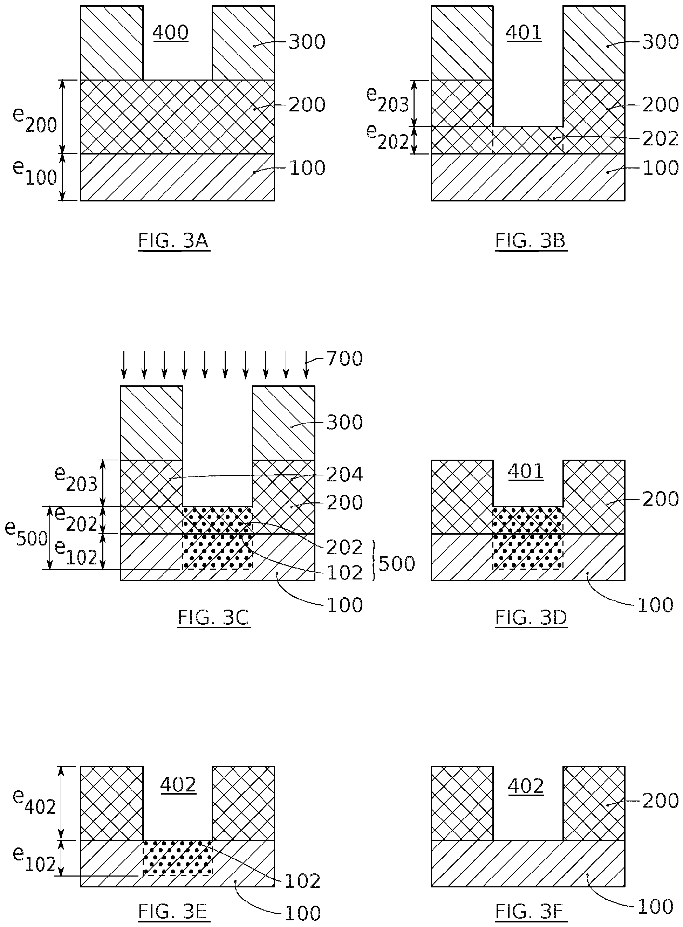

Un premier mode de réalisation de la présente invention va maintenant être décrit en détail en référence aux figures 2 et 3A à 3F.

L'empilement de départ comprend au moins une couche à base de GaN 100 surmontée d'au moins une couche diélectrique 200.

La couche à base de GaN 100 est de préférence supportée par au moins un substrat de support non illustré sur les figures.

La couche à base de GaN 100 peut être une couche homogène ou un empilement de couches à base de GaN, par exemple une couche comprenant de l'AIGaN. La couche à base de GaN peut non dopée ou dopée. Dans ce cas elle pourra être dopée par l'une au moins des espèces suivantes : Mg, Si, P, O, Ca, C.

De préférence, la couche à base de GaN 100 est disposée directement au contact de la couche diélectrique 200.

La couche diélectrique 200 est formée d'un matériau à base de l'un parmi le SixNy et le SixOy, x et y étant des entiers.

De préférence, la couche à base de GaN 100 présente une épaisseur e100 supérieure ou égale à 10 nm (10-9 mètres) et de préférence supérieure ou égale à 20nm. Généralement e100 est comprise entre 10nm et 40 nm. De préférence 25nm.

De préférence, la couche diélectrique 200 présente une épaisseur e200 supérieure ou égale à 40 nm et de préférence supérieure ou égale à 50 nm. Généralement e200 est comprise entre 50 nm et 100 nm, et de préférence entre 75 et 85 nm. Les couches 100 et 200 s'étendent principalement dans des plans parallèles. Leurs épaisseurs e100, e200 sont donc mesurées selon une direction perpendiculaire à ces plans.

De manière préférée mais non limitative, la couche diélectrique 200 est déposée à une température supérieure ou égale à 500°C.

Le procédé qui va être décrit par la suite permet d'obtenir une gravure particulièrement précise d'une couche diélectrique 200 déposée à une température supérieure à 500°C et de préférence supérieure à 550°C.

Selon un mode de réalisation, la couche diélectrique 200n par exemple du SiN, est déposée in-situ par MOCVD (épitaxie en phase vapeur aux organométalliques) à 1050°C et est complété par un dépôt CVD (dépôt chimique en phase vapeur), de préférence à basse pression (LPCVD) à plus de 700°C.

Une première étape (Etape E1) consiste à réaliser une ouverture partielle 401 dans la couche diélectrique 200. Par ouverture partielle, on entend une ouverture non traversante, ou bien la réalisation d'un motif en creux qui laisse en place une portion résiduelle 202.

Cette ouverture partielle 401 est réalisée par lithographie. Pour cela, on aura, préalablement à l'ouverture de la couche diélectrique 200, déposé une couche, par exemple une couche de résine. Au moins une ouverture 400, de préférence traversante, est réalisée dans la couche de résine pour former un masque de résine 300.

L'ouverture partielle 401 de la couche diélectrique 200 est réalisée par gravure à travers le masque de résine 300.

Cette gravure est de préférence effectuée à base d'une chimie fluorocarbonée. Dans ce cas, on pourra utiliser un réacteur plasma à couplage capacitif (CCP) ou un réacteur plasma à couplage inductif (ICP).

Cette gravure est effectuée de sorte à conserver, dans le fond du motif en creux réalisé dans la couche diélectrique 200, une portion résiduelle 202. Cette portion résiduelle 200 présente une épaisseur e202 suffisante pour bloquer les espèces de la chimie de gravure, afin que ces espèces ne pénètrent pas dans la couche à base de GaN 100. On évite ainsi l'incorporation de fluor dans la couche à base de GaN 100. Par ailleurs, la couche résiduelle 200 empêche aussi toutes modifications autres telles que des modifications stœchiométriques, structurelles, électrostatiques, du GaN qui peut être provoqué par la gravure plasma.

Ainsi, e202 est supérieure à 4 nm. De préférence e202 est comprise entre 5 nm et 30 nm.

Sur la figure 3B, l'épaisseur e203 correspond à l'épaisseur gravée de la couche 200 lors de cette étape d'ouverture partielle. Ainsi, e200 = e202 + e203.

L'étape suivante illustrée en figure 3C (Etape E3 illustrée en figure 2), consiste à modifier, par implantation 700 d'ions, lesdits ions étant pris à base d'hydrogène (H) et/ou d'hélium (He), la portion résiduelle 202 sur toute son épaisseur e202. Par ailleurs, cette modification est effectuée sans que l'on ait besoin d'arrêter l'implantation avant la couche à base de GaN 100. Ainsi, lors de l'implantation 700 des ions pénètrent également dans la couche à base de GaN 100.

Ainsi, l'implantation 700 est configurée, en particulier sa direction et l'énergie des ions, de sorte à ne pas s'arrêter sur une face inférieure de la couche diélectrique 200 mais de sorte à se poursuivre jusque dans la couche à base de GaN 100.

Ainsi, une zone 102 de la couche à base de GaN 100 est implantée. Cette zone 102 est située au droit de l'ouverture partielle 401. Cette zone 102 présente une épaisseur e102.

L'épaisseur e102 est supérieure à 4 nm. De préférence, e102 est comprise entre 5 nm et 30 nm. De préférence e102 est inférieure à l'épaisseur totale e100 de la couche à base de GaN 100 au droit de l'ouverture 401.

Ainsi, l'implantation 700 est réalisée dans une zone 500 comprenant la portion résiduelle 202 et la zone 102. L'épaisseur e500 totale de la zone 500 implantée est donc égale à e500 = e102 + e202.

De préférence, la modification par implantation 700 est anisotrope. Elle est effectuée selon une direction d'implantation parallèle à la direction principale de la gravure partielle. La gravure partielle définit une ouverture 401 délimitée par des flancs perpendiculaires aux plans principaux dans lesquels s'étendent les couches 100 et 200. La direction principale d'implantation 700 est parallèle à ces flancs. Ainsi, les ions sont implantés au droit de l'ouverture 401. Ils sont donc implantés dans la portion résiduelle 202 et dans la zone 102 située à l'aplomb de l'ouverture partielle 401. Les régions adjacentes 204 à la portion résiduelle 202 et à la zone 102 ne sont pas implantées.

Ainsi, le procédé proposé ne nécessite pas de stopper l'implantation de manière précise à l'interface entre la couche diélectrique 200 et la couche à base de GaN 100, ou sur une face inférieure de la couche diélectrique 200 s'il existe une couche intermédiaire entre la couche à base de GaN 100 et la couche diélectrique 200. Cela permet de s'assurer que toute la couche diélectrique 200, située au droit de l'ouverture 401, est effectivement implantée.

Les paramètres de l'implantation 700 de la couche diélectrique 200 sont réglés, en particulier la nature et la concentration des ions ainsi que l'énergie des ions de sorte à ce que la vitesse de gravure du matériau modifié de la couche diélectrique 200 soit supérieure à celle du matériau non modifié de la couche diélectrique 200. L'étape de modification permet ainsi d'augmenter la sélectivité de la gravure de la couche diélectrique 200, dans la portion résiduelle 202 modifiée, vis-à-vis des portions non modifiées de la couche diélectrique 202.

Typiquement, cette modification comprend l'implantation d'ions à base d'hydrogène (H, H+, H2+, H3+, etc....). Selon un autre mode de réalisation, les ions implantés sont des ions d'hélium (He) ou un mélange d'ions d'hélium et d'hydrogène (H/He). Ces ions peuvent provenir par exemple des gaz suivants introduits dans le réacteur: H2, HBr; NH3.

Ces ions sont implantés dans un réacteur ou dans un implanteur.

Des exemples d'implantation seront décrits par la suite.

La figure 3D illustre le retrait du masque de résine 300 (Etape E4 illustrée en figure 2). Cette étape, habituellement qualifiée par le vocable anglais de stripping, comprend par exemple une gravure par un plasma d'oxygène. Cette gravure peut être suivie d'un nettoyage humide permettant le retrait des résidus de gravure. Par exemple, une solution de type EKC265 fournie par la société DuPont^{™}, à base d'agents organiques actifs tel qu'un agent nucléophile, un agent réducteur et un agent chélatant.

On remarquera que lors de cette étape E4, la couche à base de GaN 100 reste masquée par la portion résiduelle 202. La couche à base de GaN 100 ne subit donc pas d'oxydation lors de cette étape de stripping du masque de résine 300. Cela représente un avantage significatif par rapport aux solutions connues dans lesquelles l'étape de stripping du masque de résine conduit à oxyder et donc à altérer la couche d'AIGaN.

La figure 3E illustre le retrait de la portion résiduelle 202 sélectivement aux portions non modifiées 204 de la couche diélectrique 200 et à la couche à base de GaN 100 (Etape E5 illustrée en figure 2).

De préférence, la gravure sélective de la portion résiduelle 202 formée du matériau diélectrique modifié est obtenue à l'aide d'une solution à base d'acide fluorhydrique (HF) ou à l'aide d'une solution à base d'acide phosphorique (H3PO4).

A titre d'exemple pour une couche diélectrique en SiN, avec une solution à base d'acide fluorhydrique (HF), le rapport de vitesse de gravure entre SiN modifié et SiN non modifié est de l'ordre de 30. A titre d'exemple également, le rapport de vitesse de gravure entre SiN modifié et l'AlGaN modifié est > 5. De manière inattendue, il s'avère que la consommation par une solution à base de HF de l'AlGaN modifié par implantation est très faible voire nulle.

D'autres exemples d'étapes de gravure sélective seront décrits en détail par la suite.

Toute l'épaisseur e202 de la portion résiduelle 202 ayant été modifiée par implantation, toute cette épaisseur est retirée lors de la gravure sélective. L'ouverture 402 de la couche diélectrique 200 est alors traversante. Une face supérieure de la couche à base de GaN 100 est donc mise à nu au droit de l'ouverture 402.

L'étape suivante (Etape E6 illustrée en figure 2) consiste à effectuer un recuit de l'empilement comprenant la couche à base de GaN 100.

Ce recuit est effectué dans les conditions suivantes:
- température supérieure comprise entre 300°C et 900°C.
- Durée supérieure à 30s, et de préférence comprise entre 1min et 5mins.
- Pression comprise entre 1 bar et 10⁻⁸ bars et avantageusement la pression atmosphérique.

Alors que la couche à base de GaN se trouve fortement impactée par l'implantation, le recuit avec les paramètres mentionnés ci-dessus, permet d'obtenir un matériau à base de GaN dont les propriétés sont proches de celles que ce matériau présentait avant implantation. Typiquement, les propriétés électriques de la zone du matériau à base de GaN implantée puis soumise au recuit sont identiques à, ou très proches de, celles de ce même matériau après croissance par épitaxie.

On notera que ce type de recuit n'a pas donné de résultats satisfaisants lorsque la gravure pour ouvrir toute l'épaisseur de la couche diélectrique est basée sur une chimie fluorocarbonée.

Deux exemples particuliers vont maintenant être décrits. Dans chacun de ces exemples seront mentionnés :
- dans un premier tableau les conditions de l'implantation par plasma qui ont conduit à la modification de la zone 102 de la couche à base de GaN 100,
- la résistance de couche Rₛₕₑₑₜ mesurée après implantation mais avant l'étape de recuit,
- Selon un mode de réalisation, pour une hétérostructure AlGaN/GaN ou AlGaN/AlN/GaN, Rₛₕₑₑₜ est la résistance du canal bi-dimensionnel d'électron, présent en surface du GaN, à l'l'interface AlGaN/GaN ou AIGaN/AIN. La couche 100 est de l'AlGaN et on veut mesurer la résistance du 2DEG qui se forme en dessous (non représenté sur les graphes).
- dans un deuxième tableau les conditions du recuit appliqué à la couche à base de GaN 100,
- la résistance de couche Rₛₕₑₑₜ mesurée pour la couche à base de GaN 100 après recuit.
- On rappellera que la résistance de couche, habituellement désignée par Rₛₕₑₑₜ s'exprime en Ω/ □ ou Q.m. La résistance de couche Rₛₕₑₑₜ se mesure par exemple par la méthode connue des quatre pointes. Dans chacun des exemples ci-dessous, la nature de la couche à base de GaN 100 est identique. Elle est faite d'AIGaN. Par comparaison aux exemples qui suivent, la résistance de couche Rₛₕₑₑₜ du canal d'électron qui se forme en présence de l'hétérostructure AlGaN/GaN (ou AlGaN/AIN/GaN), après croissance par épitaxie mais avant les étapes d'implantation et de recuit du procédé proposé est de 350 Ω/ □.

**Tableau 1**

| | Exemple 1 | |
|---|---|---|
| **Implantation de la couche à base de GaN 100** | | |
| Matériau de la couche à base de GaN | | AIGaN |
| Épaisseur modifiée e102 de la couche à base de GaN : | | Quelques nanomètres |
| Nature du gaz injecté dans le réacteur pour former le plasma | | Gaz à base d'Hélium, typiquement (He) |
| Débit du gaz injecté dans le réacteur | | 50 sccm |
| Puissance de la source : | | 600 Watts |
| Puissance de la polarisation (bias) : | | 30 Watts |
| Tension de polarisation (bias) : | | 45 V |
| Pression : | | 10 milli Torr |
| Durée : | | 200 s |

**Tableau 2**

| **Rₛₕₑₑₜ pour la couche à base de GaN mesurée avant recuit** | |
|---|---|
| Rₛₕₑₑₜ | Pas mesurable |

**Tableau 3**

| **Recuit** | |
|---|---|
| Température du recuit: | 600°C |
| Durée | 20 minutes |
| Gaz | N2 |
| Pression : | Pression atmosphérique |

**Tableau 4**

| **Rₛₕₑₑₜ pour la couche à base de GaN mesurée après recuit** | |
|---|---|
| Rₛₕₑₑₜ | 361 Ω/ □ |

**Tableau 5**

| | Exemple 2 | |
|---|---|---|
| **Implantation de la couche à base de GaN 100** | | |
| Matériau de la couche à base de GaN | | AIGaN |
| Épaisseur modifiée e102 de la couche à base de GaN : | | Quelques nanomètres |
| Nature des gaz injectés dans le réacteur pour former le plasma | | CF4/CH2F2/O2/He |
| Débit des gaz injectés dans le réacteur | | |
| | | CF4 : 27 sccm |
| | | CH2F2 : 50 sccm |
| | | O2 : 27 sccm |
| | | He : 100 sccm |
| | | |
| Puissance de la source : | | 400 Watts |
| Puissance de la polarisation (bias) : | | 70 Watts |
| Tension de polarisation (bias) : | | 420 V |
| Pression : | | 32 milli Torr |
| Sur gravure | | 64% exprimé en % du temps de gravure effectif |
| Durée : | | En fonction de l'épaisseur de la couche diélectrique. 18 seconde par exemple, sur gravure comprise pour 10 nm de SiN avec les conditions ci-dessus |

**Tableau 6**

| **Rₛₕₑₑₜ pour la couche à base de GaN mesurée avant recuit** | |
|---|---|
| Rₛₕₑₑₜ | Pas mesurable |

**Tableau 7**

| **Recuit** | |
|---|---|
| Température du recuit: | 600°C |
| Durée | 20 minutes |
| Gaz | N2 |
| Pression : | Pression atmosphérique |

**Tableau 8**

| **Rₛₕₑₑₜ pour la couche à base de GaN mesurée après recuit** | |
|---|---|
| Rₛₕₑₑₜ | 975 Ω/ □ |

Il ressort clairement de ces exemples qu'après implantation 100 et avant recuit, les caractéristiques électriques de la couche à base de GaN 100, en particulier la résistance de couche Rsheet est très fortement dégradée. En revanche, le recuit permet d'obtenir un matériau à base de GaN dont les propriétés sont proches du matériau post-épitaxie.

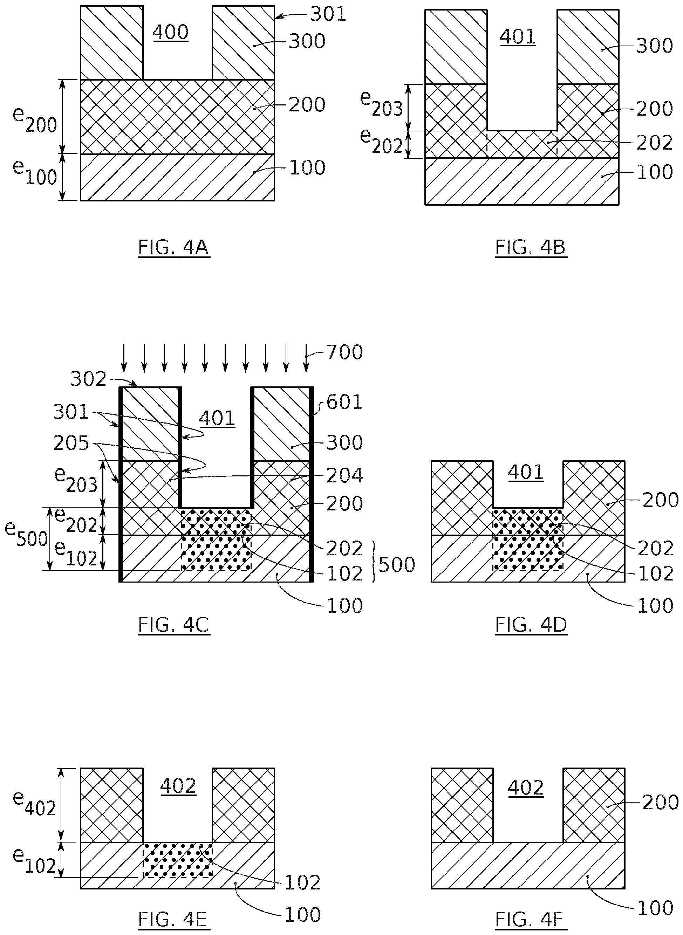

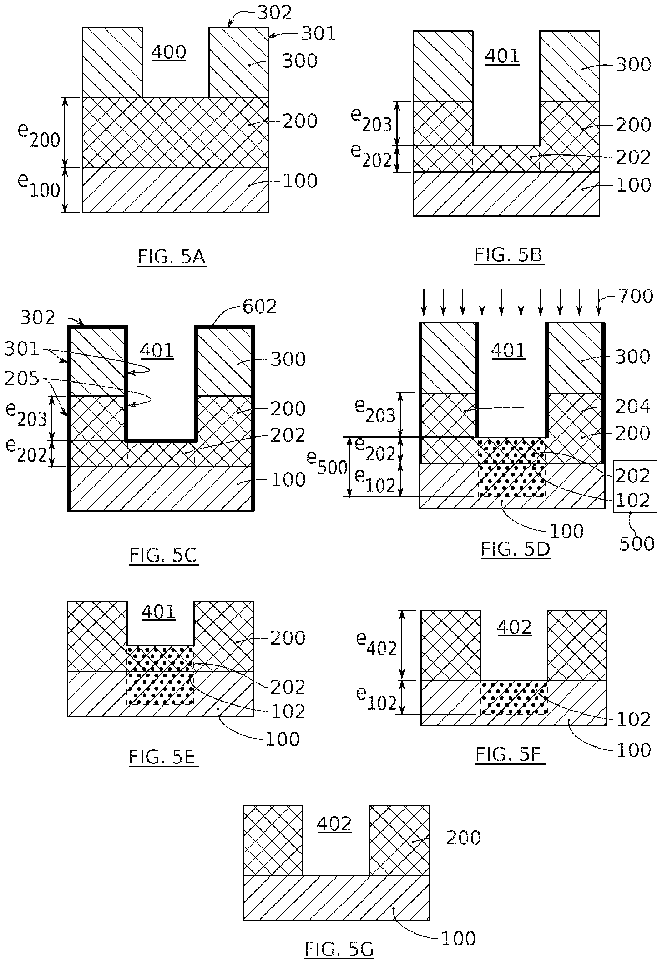

Deux modes de réalisation alternatifs vont maintenant être décrits en référence aux figures 4A à 4F, 5A à 5G et à la figure 2.

Dans ces deux modes de réalisation alternatifs, l'objectif est d'éviter, lors de l'implantation, une modification des côtes du masque de résine 300 sous l'effet du bombardement.

Ces deux modes de réalisation alternatifs sont identiques aux modes de réalisation décrits précédemment en référence aux figures 3A à 3F à l'exception des étapes qui seront spécifiées. Ainsi, toutes les caractéristiques, étapes, effets techniques et avantages mentionnés précédemment s'appliquent à ces deux modes de réalisation alternatifs.

Un premier mode de réalisation alternatif va être décrit en référence aux figures 4A à 4F.

Les étapes, illustrées en figures 4A et 4B sont identiques aux étapes décrites en référence aux figures 3A et 3B.

Ce mode de réalisation diffère de celui décrit précédemment en ce que lors de l'étape E3 de modification, l'implantation 700 conduit à former sur les surfaces parallèles à la direction principale d'implantation un film de protection 601. Ainsi, sur les flancs 301 des motifs du masque de résine 300 ainsi que sur les flancs 205 découverts de la couche diélectrique 200, un film de protection 601 est formé. Ce film de protection 601 est un film carboné. Il protège ces flancs 301, 205 lors de l'étape de modification ce qui permet d'améliorer le contrôle dimensionnel du masque de résine 300 et du masque dur formé par la couche diélectrique 200.

Selon un exemple de réalisation, lors de l'étape E3 de modification par implantation, la portion résiduelle 202 est mise en présence d'un plasma dans lequel on introduit du Cx1Hy1 où x1 est la proportion de carbone et y1 est la proportion d'hydrogène (H). Ce plasma comprend également des ions plus lourds que l'hydrogène. Les conditions du plasma, en particulier la concentration en Cx1Hy1, l'énergie des ions et la direction principale d'implantation sont choisies de manière à ce que :
- le plasma crée un bombardement d'ions à base d'hydrogène (H, H⁺, H₂⁺, H₃⁺ etc.) provenant du Cx₁Hy₁, le bombardement étant anisotrope selon une direction privilégiée parallèle aux flancs 301 du masque de résine 300,
- des espèces chimiques du plasma contenant du carbone provenant du CxHy forment le film de protection 601 carboné, notamment sur des surfaces parallèles à la direction du bombardement, telles que les flancs 301 du masque de résine 300 ;
- le plasma crée un bombardement d'ions plus lourds que l'hydrogène qui empêche auxdites espèces chimiques du plasma contenant du carbone et provenant du Cx₁Hy₁ de former un film de protection 601 carboné notamment sur les surfaces perpendiculaires à la direction du bombardement. Ces surfaces perpendiculaires à la direction du bombardement comprennent notamment la face supérieure de la portion résiduelle 202.

De manière particulièrement avantageuse, il a été constaté que le bombardement d'ions plus lourds que l'hydrogène tels que l'He permet aux espèces chimiques du plasma contenant du carbone provenant du Cx1Hy1 de former le film carboné notamment sur des surfaces parallèles à la direction du bombardement et empêche par ailleurs à ces espèces chimiques contenant du carbone de former un film carboné sur les surfaces de la couche diélectrique 200 qui sont perpendiculaires à la direction du bombardement.

Le bombardement d'ions plus lourds que l'hydrogène détruit en effet le film de protection 601 carboné qui aurait tendance à se déposer sur le fond de l'ouverture 401 qui est perpendiculaire à la direction du bombardement.

Lors de l'étape de retrait E4, cette gravure grave les surfaces de la portion résiduelle 202 modifiée qui ne sont pas recouvertes par le film carboné.

On notera néanmoins que la face supérieure 302 de la couche de résine peut être protégée par ce film de protection 600. En effet, la couche de résine étant une couche carbonée, les atomes de carbone provenant du Cx1Hy1 se déposent très rapidement sur cette couche de résine et y adhèrent par affinité chimique. Le bombardement ionique ne suffit donc pas à empêcher la formation de ce film carboné. Ce film carboné protège donc la face supérieure de la couche de résine.

Ainsi, ce mode de réalisation permet de protéger efficacement le masque de résine 300 grâce au film de protection 601 tout en permettant d'implanter la portion résiduelle 202.

Ce film de protection 601 présente une épaisseur inférieure à 5nm et de préférence inférieure à 3nm.

Selon un exemple, l'étape de modification de l'étape E3 est réalisée de manière à ce que les ions plus lourds que l'hydrogène du plasma dissocient la molécule du Cx1Hy1 de sorte à permettre aux ions hydrogène (H) provenant du Cx1Hy1 de former des ions à base d'hydrogène et de s'implanter dans la portion résiduelle 202 de la couche diélectrique 200 pour la modifier.

Selon un exemple particulier, non limitatif, le Cx1Hy1 est du CH4 et les ions plus lourds que l'hydrogène sont des ions à base d'hélium (He).

Selon un exemple, on injecte dans un réacteur plasma les gaz CH4 et He.
- Le carbone du CH4 va permettre de passiver les flancs 301 du masque de résine 300 en formant le film de protection 601.
- Le carbone dans le fond des motifs, en particulier sur la face libre de la portion résiduelle 202, ne parvient pas à former une couche puisqu'il est pulvérisé par les ions He.
- Les ions à base d'H s'implantent dans toute l'épaisseur de la portion résiduelle 202 ainsi que dans une partie de la couche à base de GaN 100 pour définir la zone 102.

Selon d'autres exemples, les ions plus lourds que l'hydrogène peuvent comprendre des ions à base de l'un parmi : l'argon (Ar), l'azote (N2), le xénon (Xe) et l'oxygène (O2). Les étapes, illustrées en figures 4D à 4F sont identiques aux étapes décrites en référence aux figures 3D et 3F.

Le film de protection 601 est retiré lors de l'étape E4 de retrait du masque de résine 300.

L'étape E5 de retrait est effectuée de manière à retirer sélectivement la portion résiduelle 202 modifiée vis-à-vis de la couche diélectrique non modifiée 204 et vis-à-vis dudit film de protection 601 carboné.

Ce mode de réalisation illustré en référence aux figures 4A à 4F est applicable aussi bien aux couches diélectriques 200 formées d'un matériau à base de SixNy que celle à base de SixOy.

Un deuxième mode de réalisation alternatif va être décrit en référence aux figures 5A à 5F et 2.

Les étapes, illustrées en figures 5A et 5B, sont identiques aux étapes décrites en référence aux figures 3A et 3B.

Ce mode de réalisation diffère de celui décrit précédemment en ce qu'après l'étape E1 d'ouverture partielle de la couche diélectrique 200 et avant l'étape E3 de modification, le procédé comprend une étape de protection du masque 300 de résine en effectuant le dépôt d'une couche de protection 602. Cette étape, uniquement optionnelle, est référencée E2 en figure 2.

Comme illustré en figure 5C, le film de protection 602 est de préférence déposé de manière conforme. Ainsi, il recouvre les flancs 301 et les sommets 302 du masque 300 ainsi que les flancs 205 de la couche diélectrique 200. Ce film de protection 602 couvre également la face supérieure de la portion résiduelle 202.

De préférence, ce film de protection 602 est déposé dans le même réacteur que celui ayant servi à réaliser l'étape E1 d'ouverture partielle de la couche diélectrique et/ou dans le même réacteur que celui qui sera utilisé lors de l'étape E3 de modification.

Ce film de protection 602 est de préférence un polymère.

Selon un exemple, ce dépôt est effectué à base d'une chimie fluorocarbonée. Le film de protection 602 déposé et alors à base de Cx0Hy0Fz0, x0, y0 et z0 étant des entiers.

Ce film de protection 602 présente une épaisseur inférieure à 10nm et de préférence inférieure à 5nm.

Ainsi, lors de l'étape E3 de modification, le bombardement des ions pulvérise ce film de protection 602. Ainsi, comme illustré en figure 5D, lors de l'implantation 700 ce film de protection 602 disparaît sur les surfaces qui ne sont pas parallèles à la direction principale d'implantation. Le film de protection 602 disparaît donc sur la face supérieure du masque 300 de résine ainsi que dans le fond de l'ouverture 401 formée par la face supérieure de la couche résiduelle 202. Ce film de protection 602 ne bloque alors pas l'implantation des ions au sein de la couche résiduelle 202 et au sein d'une partie de la couche à base de GaN 100.

Pour autant, le bombardement ionique ne pulvérise pas le film de protection 602 déposé sur les surfaces parallèles à la direction de ce bombardement. Ainsi, les flancs 301 du masque 300 de résine restent protégés par ce film de protection 602 lors de l'implantation 700. Ce film de protection 602 permet donc de conserver les côtes du masque 300 de résine.

Selon un exemple, le film de protection 602 est retiré lors de l'étape E4 de retrait du masque 300 de résine. Par exemple, le retrait du film de protection 602 peut ainsi être effectué avec la même chimie que celle utilisée pour retirer le masque de résine 300. Ainsi, on pourra par exemple utiliser un plasma d'oxygène suivi d'un nettoyage humide.

Ainsi, le résultat de l'étape E4, illustré en figure 5E, est identique aux résultats illustrés en figure 3D.

En outre, les étapes, illustrées en figures 5F et 5G sont identiques aux étapes décrites en référence aux figures 3E et 3F.

Ce mode de réalisation, illustré en référence aux figures 5A à 5G, est applicable aussi bien aux couches diélectriques 200 formées d'un matériau à base de SixNy que celles à base de SixOy.

Les paragraphes ci-dessous présentent différents modes de réalisation pour la réalisation de l'étape E3 de modification par implantation de la couche diélectrique 200 et l'étape E5 de retrait de la couche diélectrique modifiée par implantation sélectivement à la couche diélectrique non modifiée.

### Modification de la couche diélectrique 202

Comme mentionné ci-dessus en référence aux figures 3C, 4C, 5D, la modification anisotrope de la portion résiduelle 202 de la couche diélectrique 200 est effectuée par une implantation anisotrope 700 d'ions, lesdits ions étant pris à base d'hydrogène (H) et/ou d'hélium (He).

Comme indiqué ci-dessus, un avantage du procédé proposé est qu'il n'est pas nécessaire d'arrêter l'implantation avant la couche à base de GaN 100. Cela permet de s'assurer que toute l'épaisseur de la couche diélectrique 200 est modifiée tout en relâchant les contraintes de procédé.

Selon un premier exemple, l'implantation anisotrope 700 peut être réalisée dans un implanteur classique (habituellement désigné par « beamline »), c'est-à-dire avec une implantation par faisceau d'ions.

La direction d'implantation reste constante tout au long de l'implantation. Cette direction est parallèle aux flancs 301 du masque 300 de résine et aux flancs 205 de la couche diélectrique 200.

Les espèces implantées sont de l'hydrogène (H).

A l'étape suivante, les portions modifiées 202 de la couche diélectrique 200 pourront ainsi être retirées par gravure de manière sélective vis-à-vis de la couche à base de GaN 100 et vis-à-vis des portions 204 non modifiées de la couche diélectrique 200. Cette gravure est de préférence une gravure humide car plus douce pour les couches sous-jacentes. Par exemple, cette gravure est basée sur une chimie HF. Alternativement cette gravure peut être une gravure sèche.

Typiquement, la dose implantée par faisceau d'ions est supérieure à 1E13 atomes par centimètres carrés (at/cm²). Elle sera plus généralement comprise entre 1E14 et 1E17 at/cm².

Ces conditions d'implantation sont par exemple déterminées par simulation en utilisant des outils de simulation de type SRIM (stopping and range of ions matter) ou TRIM (transport simulation of ions in matter). Ces outils de simulation peuvent également être utilisés pour déterminer les conditions d'implantation pour les implantations par plasma qui seront détaillées ci-dessous.

Selon un deuxième exemple, privilégié, l'implantation anisotrope 700 peut être réalisée dans un équipement de gravure plasma. Dans ce cas, on pourra utiliser un réacteur plasma à couplage capacitif (CCP) ou un réacteur plasma à couplage inductif (ICP), ou un plasma par immersion.

L'implantation d'ions par plasma est une solution avantageuse, notamment puisqu'elle permet de contrôler avec précision la profondeur implantée afin :
- d'implanter et donc de modifier toute l'épaisseur e₂₀₂ de la portion résiduelle 202;
- d'implanter tout ou partie de l'épaisseur e₁₀₀ de la couche à base de GaN 100.
- Par ailleurs, l'intérêt du plasma est que l'on a une modification chimique notamment par implantation H, qui rend le retrait de la couche modifiée plus facile. On améliore ainsi encore plus la sélectivité de la gravure lors de l'étape E5 de retrait.
- Selon un exemple de réalisation, cette modification comprend l'implantation d'ions à base d'hydrogène (H, H⁺, H₂⁺, H₃⁺, etc....).

Selon un autre mode de réalisation les ions implantés sont des ions d'hélium (He) ou un mélange d'ions d'hélium et d'hydrogène (H/He).

Ces ions peuvent provenir par exemple des gaz suivants introduits dans le réacteur : H2, HBr ; NH3.

On réglera les paramètres suivants afin d'obtenir une implantation anisotrope 200 par implantation par plasma, sur une profondeur précise correspondant au moins à toute l'épaisseur e202 de la couche diélectrique 200.

Ces paramètres sont en particulier :
- la pression régnant à l'intérieur de la chambre du réacteur plasma. De préférence, cette pression est inférieure à 100 milli Tor, ceci afin d'éviter une implantation isotrope ;
- la température sera de préférence inférieure à 100°C, afin de modifier efficacement la couche diélectrique 200.

Pour tous ces modes de réalisation, les conditions d'implantation peuvent être déterminées par simulation à l'aide d'un outil SRIM ou TRIM.

L'utilisation d'un plasma permet une implantation à des profondeurs plus faibles que les profondeurs minimales que l'on peut obtenir avec des implanteurs. Ainsi, une implantation par plasma permet d'implanter de manière continue des épaisseurs fines typiquement de quelques nanomètres. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

En plus des avantages mentionnés ci-dessus, l'implantation par plasma permet d'utiliser le même réacteur plasma pour :
- le dépôt optionnel du film de protection 602 formé d'un polymère,
- la modification anisotrope de la portion résiduelle 202 est de la zone 102 de la couche à base de GaN 100,
- le retrait du masque 300 de résine.
- Cela permet de simplifier le procédé, de réduire les cycles de fabrication et d'abaisser les coûts

Selon encore un autre mode de réalisation, lors de l'étape E3 de modification, le plasma utilisé est formé à partir d'un gaz comprenant au moins un premier composant gazeux non carboné dont la dissociation génère lesdits ions légers et un deuxième composant gazeux comprenant au moins une espèce favorisant la dissociation du premier composant pour former lesdits ions légers, dans lequel le ratio de gaz entre le premier composant et le deuxième composant est compris entre 1 :19 et 19 :1. De préférence ledit ratio est compris entre 1 :9 et 9 :1 et de préférence entre 1 :5 et 5 :1.

De préférence :
- le premier composant est choisi parmi l'hydrogène (H2), le nitrure de silicium (SiH4), le nitrure d'hydrogène (NH3) ou le bromure d'hydrogène (HBr).
- le deuxième composant est choisi parmi l'hélium (He), l'azote (N2), l'argon (Ar) ou le xénon (Xe).

De préférence, le débit du premier composant est compris entre 10 et 1000 sccm (centimètre cube par minute) et le débit du deuxième composant est de préférence compris entre 10 et 1000 sccm.

Avantageusement, le rôle du premier composant est de modifier, par bombardement ionique, la structure cristalline de la couche diélectrique afin de pouvoir, par la suite, différencier la couche diélectrique initiale de la couche diélectrique modifiée. Le problème est que si nous utilisons un plasma à base uniquement d'un seul composant, de l'hydrogène (H2), par exemple, le risque est de ne pas modifier de façon uniforme la couche diélectrique 200 dans son épaisseur. Cela entraîne un mauvais contrôle de la profondeur réelle jusqu'à laquelle la couche modifiée présente une sélectivité significativement améliorée. Dans ce cas, la profondeur de l'implantation ionique dans la couche diélectrique n'est pas équivalente à l'épaisseur de la couche diélectrique modifiée dont la sélectivité est significativement améliorée et qui sera gravée à la suite du bombardement.

L'ajout d'un deuxième composant agissant avantageusement comme un gaz de dissociation (tel que l'argon, l'hélium, le xénon, l'azote), permet de faciliter la dissociation du premier composant et, par ce biais, de favoriser l'implantation dudit premier composant dissocié dans la couche diélectrique, sous forme d'ions légers. La dose implantée est donc plus élevée sans pour autant avoir besoin d'augmenter la profondeur maximale d'implantation.

Il est donc important de trouver un juste ratio entre la teneur en premier composant et en deuxième composant dans le plasma destiné à modifier la couche diélectrique. Avantageusement, le ratio de gaz entre le premier composant et le deuxième composant est supérieur à 1:19 et inférieur à 19 :1.

Cette implantation 700 d'ions est réalisée de préférence pleine plaque. Elle permet de modifier la couche diélectrique 200 sans pour autant la pulvériser. Ainsi, il s'agit essentiellement d'une modification chimique, l'ajout d'ions dans cette couche diélectrique 200 changeant sa sélectivité. Ainsi, les portions modifiées 202 de cette couche 200 se graveront beaucoup plus facilement que les portions 204 non modifiées.

### Retrait sélectif des portions 202 modifiées

Pour chacun des modes de réalisation mentionnés précédemment et basés sur une implantation 700 d'ions, plusieurs variantes de réalisation pour le retrait sélectif des portions 202 modifiées de la couche diélectrique 200 sont possibles.

Des chimies de gravure sèches ou humides mentionnées peuvent être utilisées.

Selon un mode de réalisation, l'étape de retrait des portions 202 modifiées de la couche diélectrique 200 est effectuée par gravure humide sélective vis-à-vis du matériau à base de GaN.

De préférence, la gravure sélective vis-à-vis du GaN est obtenue à l'aide d'une solution à base d'acide fluorhydrique (HF) ou à l'aide d'une solution à base d'acide phosphorique (H3PO4). Dans ces deux cas, on obtient une excellente sélectivité de la gravure de la couche diélectrique 200 modifiée vis-à-vis de la couche diélectrique 200 non modifiée et vis-à-vis de la couche à base de GAN.

A titre d'exemple pour une couche diélectrique 200 en SiN, avec une solution à base d'acide fluorhydrique (HF), le rapport de vitesse de gravure entre SiN modifié et SiN est de l'ordre de 30.

A titre d'exemple également avec une solution à base d'acide fluorhydrique (HF), l'AIGaN non modifiée n'est pas gravé et l'AIGaN modifiée n'est pas gravé ou est gravée bien plus lentement que le SiN modifié.

Cela permet de retirer entièrement les portions 202 modifiées sans consommer les portions non modifiée 204 sur les flancs 205 de la couche diélectrique 200 est sans consommer la couche à base de GaN 100.

Selon un mode de réalisation, particulièrement avantageux lorsque la couche diélectrique 200 est en SixNy, la gravure sélective des portions modifiées 202 vis-à-vis des portions non modifiées comprend une gravure humide à base d'une solution comprenant de l'acide fluorhydrique (HF) diluée à x% en masse, avec x≤0.2 et présentant un pH inférieur ou égal à 1.5.

De préférence, le pH est inférieur ou égal à 1.3, de préférence inférieur ou égal à 1 et de préférence strictement inférieur à 1.

De préférence, x≤0.15 et de préférence x≤0.1. Selon un exemple, x est sensiblement égal à 0.1.

De préférence, la solution est obtenue par ajout d'au moins l'un parmi : acide chlorhydrique (HCI), acide sulfurique H2SO4, acide nitrique HNO3.

Par ailleurs, de manière particulièrement surprenante cette gravure permet d'augmenter de manière très significative la sélectivité de la gravure de la couche diélectrique modifiée vis-à-vis des matériaux à base d'oxyde de silicium, désigné de manière générale SiOy dans la présente demande de brevet, avec y entier supérieur ou égal à 1.

Cette sélectivité améliorée est très avantageuse puisqu'il arrive parfois qu'un masque dur sur le sommet d'une grille de transistor ou une tranchée d'isolation, à base de SiOy, soit présent lors de l'étape de gravure.

Il s'ensuit que le masque dur ou les tranchées d'isolation ne sont pas altérés par la gravure de la portion modifiée 202. Ils peuvent donc pleinement jouer leurs rôles.

Selon un autre mode de réalisation, lorsque la couche diélectrique 200 est à base de SixNy l'étape de retrait des portions modifiées 202 peut être effectuée par gravure sèche sélective vis-à-vis des portions 204 non modifiées de la couche diélectrique 200 et vis-à-vis du matériau à base de GaN. On peut pour cela utiliser un plasma délocalisé (habituellement désigné par le vocable anglais « remote plasma ») sans bombardement.

Selon un mode de réalisation, la gravure sèche est effectuée dans un plasma formé dans une enceinte confinée à partir de trifluorure d'azote (NF3) et d'ammoniaque (NH3).

Avantageusement, la gravure sèche comprend : une étape de gravure consistant en la formation de sels solides ; une étape de sublimation des espèces solides. Ce mode de réalisation permet d'obtenir une très bonne sélectivité de la gravure du nitrure modifié par rapport au nitrure non modifié et au matériau à base de GaN. En particulier, cette sélectivité de la gravure est très supérieure (typiquement un facteur 10 au moins) à celle obtenue avec une solution de HF.

Selon un autre mode de réalisation, l'étape de retrait des portions 202 modifiées vis-à-vis des portions 204 non modifiées comprend une gravure sèche réalisée par la mise en présence d'un mélange gazeux, de préférence uniquement gazeux, comprenant au moins un premier composant à base d'acide fluorhydrique (HF). L'acide fluorhydrique transforme en résidus non-volatiles, de préférence non-volatiles à température ambiante, les portions 202 modifiées de la couche diélectrique 200.

Avantageusement, l'étape de retrait des portions 202 comprend, uniquement après la gravure sèche, un retrait des résidus non-volatiles à température ambiante par un nettoyage humide ou un recuit thermique de sublimation.

Avantageusement, la gravure sèche consomme les portions 202 modifiées de la couche diélectrique 200 préférentiellement aux portions 204 non modifiées et à la couche à base de GaN 100. Ainsi, le risque de consommation excessive de la zone 102 à base de GaN est réduit, voire supprimé.

Au vu de la description qui précède, il apparaît clairement que le procédé proposé permet de retirer toute la couche diélectrique sans altérer la couche à base de GaN. Le procédé proposé améliore ainsi considérablement les performances des dispositifs à base de GaN. Par ailleurs ce dispositif est fiable, aisément reproductible et peu coûteux. En outre, il permet de relâcher les contraintes par rapport à des procédés qui nécessiteraient de stopper l'implantation de la couche diélectrique avant la couche à base de GaN 100.

L'invention n'est pas limitée aux modes de réalisations précédemment décrits et s'étend à tous les modes de réalisation couverts par les revendications.

## Revendications

1. Procédé de gravure d'une couche diélectrique (200) située sur au moins une couche à base de nitrure de gallium (GaN) (100), la couche diélectrique (200) étant formée d'un matériau à base de l'un parmi le SixNy et le SixOy avec x et y entiers non nuls, le procédé comprenant au moins les étapes suivantes:
- première gravure de la couche diélectrique (200) sur une partie seulement d'une épaisseur e₂₀₀ de la couche diélectrique (200) pour définir dans la couche diélectrique (200) au moins une ouverture partielle (401) et au moins une portion résiduelle (202) située au droit de l'ouverture (401) et présentant une épaisseur e₂₀₂,
- implantation (700) d'ions au droit de l'ouverture partielle (401) sur une épaisseur supérieure à l'épaisseur e₂₀₂ de sorte à:
• modifier le matériau de la couche diélectrique (200) au droit de l'ouverture (401) sur toute l'épaisseur e₂₀₂ de la portion résiduelle (202),
• modifier le matériau de la couche à base de GaN (100) sur une portion (102) de la couche à base de GaN (100) située au droit de l'ouverture (401),
lesdits ions étant pris à base d'hydrogène (H) et/ou d'hélium (He),
- retrait de la portion résiduelle (202) à l'aide d'une deuxième gravure, la deuxième gravure étant sélective du matériau modifié de la couche diélectrique (200) vis-à-vis du matériau non modifié de la couche diélectrique (200) et vis-à-vis du matériau modifié de la couche à base de GaN (100);
- recuit au moins de la couche à base de GaN (100) pendant une durée supérieure à D1 et une température comprise entre T1 et T2, avec D1=30s, T1 = 300°C et T2 = 900°C et de préférence T2 = 600°C.

2. Procédé selon la revendication précédente dans lequel la première gravure est basée sur une chimie fluorocarbonée.

3. Procédé selon l'une quelconque des revendications précédentes dans lequel l'épaisseur e₂₀₂ de la portion résiduelle (202) est comprise entre 5 nm et 30 nm, et de préférence entre 10 nm et 30 nm.

4. Procédé selon l'une quelconque des revendications précédentes dans lequel l'épaisseur e₂₀₂ de la portion résiduelle (202) est supérieure à 4 nm et de préférence supérieure à 10 nm.

5. Procédé selon l'une quelconque des revendications précédentes dans lequel ladite portion (102) de la couche à base de GaN (100) située au droit de l'ouverture (401) et dont le matériau est modifié lors de l'implantation (700) présente une épaisseur e₁₀₂ supérieure à 4 nm, e₁₀₂ étant de préférence comprise entre 5 nm et 30 nm.

6. Procédé selon l'une quelconque des revendications précédentes dans lequel l'implantation (700) est effectuée à l'aide d'un plasma.

7. Procédé selon l'une quelconque des revendications précédentes dans lequel la couche diélectrique (200) est située directement au contact de la couche à base de GaN (100).

8. Procédé selon la revendication précédente dans lequel la couche à base de GaN (100) est en AIGaN, la couche à base de GaN (100) en AIGaN surmontant une couche de GaN.

9. Procédé selon l'une quelconque des revendications précédentes dans lequel la couche diélectrique (200) est en SixNy, de préférence en nitrure de silicium (SiN), et dans lequel la couche diélectrique (200) est déposée une température supérieure ou égale à 500 °C.

10. Procédé selon l'une quelconque des revendications précédentes dans lequel la couche diélectrique (200) est en SixOy, de préférence en oxyde de silicium (SiO2), et dans lequel la couche diélectrique (200) est déposée une température supérieure ou égale à 500 °C.

11. Procédé selon l'une quelconque des revendications précédentes comprenant les étapes suivantes préalables à l'étape de première gravure :
- dépôt d'une couche de résine surmontant la couche diélectrique (200),
- ouverture de la couche de résine pour former un masque de résine (300),
ladite première gravure de la couche diélectrique (200) pour définir dans la couche diélectrique (200) au moins une ouverture partielle (401) étant effectuée à travers ledit masque de résine (300).

12. Procédé selon la revendication précédente comprenant, après ladite implantation (700) et avant le retrait de la portion résiduelle (202), un retrait du masque de résine (300), de préférence, le retrait du masque de résine (300) étant effectué au moins en partie par un plasma à base d'oxygène.

13. Procédé selon l'une quelconque des deux revendications précédentes comprenant, après ladite première gravure de la couche diélectrique (200) et avant ladite implantation (700), au moins la formation d'un film de protection (602) sur le masque de résine (300).

14. Procédé selon la revendication 11, dans lequel ladite implantation (700) est effectuée selon une direction principale et par mise en présence de la couche diélectrique (200) avec un plasma dans lequel on introduit du Cx₁Hy₁ où x₁ est la proportion de carbone (C) et y₁ est la proportion d'hydrogène (H) et comprenant des ions plus lourds que l'hydrogène; les conditions du plasma, en particulier la concentration en Cx₁Hy₁, l'énergie des ions et la direction principale d'implantation (700) étant choisies de manière à ce que :
- le plasma crée un bombardement d'ions à base d'hydrogène (H, H⁺, H₂⁺, H₃⁺ etc.) provenant du Cx₁Hy₁ selon la direction principale,
- des espèces chimiques du plasma contenant du carbone provenant du CxHy forment un film de protection (601) carboné notamment sur des surfaces parallèles à la direction du bombardement ;
- le plasma crée un bombardement d'ions plus lourds que l'hydrogène qui empêche auxdites espèces chimiques du plasma contenant du carbone et provenant du Cx₁Hy₁ de former un film de protection carboné notamment sur les surfaces du masque de résine (300) qui sont perpendiculaires à la direction principale du bombardement.

15. Procédé selon l'une quelconque des revendications précédentes dans lequel au moins deux des étapes suivantes et de préférence toutes les étapes suivantes sont effectuées dans un même réacteur :
- ladite première gravure,
- ladite implantation (700),
- ladite deuxième gravure.

## Patentansprüche

1. Verfahren zum Ätzen einer dielektrischen Schicht (200), die sich auf mindestens einer Schicht auf der Basis von Galliumnitrid (GaN) (100) befindet, wobei die dielektrische Schicht (200) aus einem Material auf der Basis von einem von SixNy und SixOy mit x und y als Ganzzahlen, die nicht null sind, gebildet ist, wobei das Verfahren mindestens die folgenden Schritte umfasst:
- erstes Ätzen der dielektrischen Schicht (200) nur auf einem Teil mit einer Dicke e₂₀₀ der dielektrischen Schicht (200), um in der dielektrischen Schicht (200) mindestens eine Teilöffnung (401) und mindestens einen Restabschnitt (202) zu definieren, der sich senkrecht zur Öffnung (401) befindet und eine Dicke e₂₀₂ aufweist,
- Implantieren (700) von Ionen senkrecht zur Teilöffnung (401) über eine Dicke, die größer als die Dicke e₂₀₂ ist, so dass:
• das Material der dielektrischen Schicht (200) senkrecht zur Öffnung (401) über die gesamte Dicke e₂₀₂ des Restabschnitts (202) verändert wird,
• das Material der Schicht auf der Basis von GaN (100) auf einem Abschnitt (102) der Schicht auf der Basis von GaN (100), der sich senkrecht zur Öffnung (401) befindet, verändert wird,
wobei die Ionen auf der Basis von Wasserstoff (H) und/oder Helium (He) herangezogen werden,
- Entfernen des Restabschnitts (202) mit Hilfe eines zweiten Ätzens, wobei das zweite Ätzen selektiv vom veränderten Material der dielektrischen Schicht (200) gegenüber dem nicht veränderten Material der dielektrischen Schicht (200) und gegenüber dem veränderten Material der Schicht auf der Basis von GaN (100) ist;
- Tempern mindestens der Schicht auf der Basis von GaN (100) während einer Dauer über D1 und bei einer Temperatur zwischen T1 und T2 mit D1 = 30 s, T1 = 300 °C und T2 = 900 °C und vorzugsweise T2 = 600 °C.

2. Verfahren nach vorangehendem Anspruch, wobei das erste Ätzen auf einer Fluorkohlenstoffchemie basiert.

3. Verfahren nach einem der vorangehenden Ansprüche, wobei die Dicke e₂₀₂ des Restabschnitts (202) zwischen 5 nm und 30 nm und vorzugsweise zwischen 10 nm und 30 nm liegt.

4. Verfahren nach einem der vorangehenden Ansprüche, wobei die Dicke e₂₀₂ des Restabschnitts (202) über 4 nm und vorzugsweise über 10 nm ist.

5. Verfahren nach einem der vorangehenden Ansprüche, wobei der Abschnitt (102) der Schicht auf der Basis von GaN (100), der sich senkrecht zur Öffnung (401) befindet und dessen Material bei der Implantation (700) verändert wird, eine Dicke e₁₀₂ über 4 nm aufweist, wobei e₁₀₂ vorzugsweise zwischen 5 nm und 30 nm liegt.

6. Verfahren nach einem der vorangehenden Ansprüche wobei die Implantation (700) mit Hilfe eines Plasmas durchgeführt wird.

7. Verfahren nach einem der vorangehenden Ansprüche, wobei sich die dielektrische Schicht (200) direkt im Kontakt mit der Schicht auf der Basis von GaN (100) befindet.

8. Verfahren nach vorangehendem Anspruch, wobei die Schicht auf der Basis von GaN (100) aus AIGaN ist, wobei die Schicht auf der Basis von GaN (100) aus AIGaN über einer GaN-Schicht liegt.

9. Verfahren nach einem der vorangehenden Ansprüche, wobei die dielektrische Schicht (200) aus SixNy, vorzugsweise aus Siliciumnitrid (SiN), ist und wobei die dielektrische Schicht (200) bei einer Temperatur von über oder gleich 500 °C aufgebracht wird.

10. Verfahren nach einem der vorangehenden Ansprüche, wobei die dielektrische Schicht (200) aus SixOy, vorzugsweise aus Siliciumoxid (SiO2), ist und wobei die dielektrische Schicht (200) bei einer Temperatur von über oder gleich 500 °C aufgebracht wird.

11. Verfahren nach einem der vorangehenden Ansprüche, umfassend die folgenden Schritte vor dem Schritt des ersten Ätzens:
- Aufbringen einer Harzschicht über der dielektrischen Schicht (200),
- Öffnen der Harzschicht, um eine Harzmaske (300) zu bilden,
wobei das erste Ätzen der dielektrischen Schicht (200) zur Definition mindestens einer Teilöffnung (401) in der dielektrischen Schicht (200) durch die Harzmaske (300) hindurch durchgeführt wird.

12. Verfahren nach vorangehendem Anspruch, umfassend, nach der Implantation (700) und vor dem Entfernen des Restabschnitts (202), ein Entfernen der Harzmaske (300), wobei das Entfernen der Harzmaske (300) vorzugsweise mindestens teilweise von einem Plasma auf der Basis von Sauerstoff durchgeführt wird.

13. Verfahren nach einem der zwei vorangehenden Ansprüche, umfassend, nach dem ersten Ätzen der dielektrischen Schicht (200) und vor der Implantation (700), mindestens das Bilden eines Schutzfilms (602) auf der Harzmaske (300).

14. Verfahren nach Anspruch 11, wobei die Implantation (700) gemäß einer Hauptrichtung und durch Zusammenbringen der dielektrischen Schicht (200) mit einem Plasma durchgeführt wird, in das Cx₁Hy₁ eingeleitet wird, wobei x₁ der Kohlenstoffanteil (C) ist und y₁ der Wasserstoffanteil (H) ist und umfassend schwerere Ionen als Wasserstoff; wobei die Bedingungen des Plasmas, insbesondere die Cx₁Hy₁-Konzentration, die Energie der Ionen und die Hauptrichtung der Implantation (700) derart ausgewählt sind, dass:
- das Plasma ein Bombardement mit Ionen auf der Basis von Wasserstoff (H, H⁺, H₂⁺, H₃⁺ usw.) aus Cx₁Hy₁ stammend gemäß der Hauptrichtung erzeugt,
- chemische Spezies des Plasmas, die Kohlenstoff aus CxHy enthalten, einen kohlenstoffhaltigen Schutzfilm (601) insbesondere auf Oberflächen bilden, die parallel zur Richtung des Bombardements sind;
- das Plasma ein Bombardement mit Ionen erzeugt, die schwerer als Wasserstoff sind, was verhindert, dass die chemischen Spezies des Plasmas, die Kohlenstoff enthalten und aus Cx₁Hy₁ stammen, einen kohlenstoffhaltigen Schutzfilm insbesondere auf den Oberflächen der Harzmaske (300) bilden, die senkrecht zur Hauptrichtung des Bombardements sind.

15. Verfahren nach einem der vorangehenden Ansprüche, wobei mindestens zwei der folgenden Schritte und vorzugsweise alle folgenden Schritte in demselben Reaktor durchgeführt werden:
- das erste Ätzen,
- die Implantation (700),
- das zweite Ätzen.

## Claims

1. Method for etching a dielectric layer (200) located on at least one gallium-nitride-based (GaN) layer (100), the dielectric layer (200) being formed from one of a SixNy- and a SixOy-based material with x and y non-zero integers, the method comprising at least the following steps:
- first etching of the dielectric layer (200) on only a part of a thickness e₂₀₀ of the dielectric layer (200) to define in the dielectric layer (200) at least one partial opening (401) and at least one residual portion (202) located in line with the opening (401) and having a thickness e₂₀₂,
- implantation (700) of ions in line with the partial opening (401) over a thickness greater than the thickness e₂₀₂ so as to:
• modify the material of the dielectric layer (200) in line with the opening (401) over the entire thickness e₂₀₂ of the residual portion (202),
• modify the material of the GaN-based layer (100) over a portion (102) of the GaN-based layer (100) located in line with the opening (401),
said ions being taken as hydrogen- (H) and/or helium- (He) based,
- removal of the residual portion (202) using a second etching, the second etching being selective of the modified material of the dielectric layer (200) with respect to the non-modified material of the dielectric layer (200) and with respect to the modified material of the GaN-based layer (100);
- annealing of at least the GaN-based layer (100) for a duration greater than D1 and at a temperature between T1 and T2, with D1=30s, T1 = 300°C and T2 = 900°C and preferably T2 = 600°C.

2. Method according to the preceding claim, wherein the first etching is based on fluorocarbon chemistry.

3. Method according to any one of the preceding claims, wherein said thickness e₂₀₂ of the residual portion (202) is between 5nm and 30nm, and preferably between 10nm and 30nm.

4. Method according to any one of the preceding claims, wherein the thickness e₂₀₂ of the residual portion (202) is greater than 4nm and preferably greater than 10nm.

5. Method according to any one of the preceding claims, wherein said portion (102) of the GaN-based layer (100) located in line with the opening (401) and the material of which is modified during the implantation (700) has a thickness e₁₀₂ greater than 4nm, e₁₀₂ preferably being between 5nm and 30nm.

6. Method according to any one of the preceding claims, wherein the implantation (700) is carried out using a plasma.

7. Method according to any one of the preceding claims, wherein the dielectric layer (200) is located directly in contact with the GaN-based layer (100).

8. Method according to the preceding claim, wherein the GaN-based layer (100) is made of AIGaN, the GaN-based layer (100) made of AIGaN over a layer of GaN.

9. Method according to any one of the preceding claims, wherein the dielectric layer (200) is made of SixNy, preferably made of silicon nitride (SiN), and wherein the dielectric layer (200) is deposited at a temperature greater than or equal to 500°C.

10. Method according to any one of the preceding claims, wherein the dielectric layer (200) is made of SixOy, preferably made of silicon oxide (SiO2), and wherein the dielectric layer (200) is deposited at a temperature greater than or equal to 500°C.

11. Method according to any one of the preceding claims, comprising the following steps before the step of first etching:
- depositing a resin layer over the dielectric layer (200),
- opening the resin layer to form a resin mask (300),
said first etching of the dielectric layer (200) to define in the dielectric layer (200) at least one partial opening (401) being carried out through said resin mask (300).

12. Method according to the preceding claim, comprising, after said implantation (700) and before the removal of the residual portion (202), a removal of the resin mask (300), preferably, the removal of the resin mask (300) being carried out at least partly by an oxygen-based plasma.

13. Method according to any one of the preceding two claims, comprising, after said first etching of the dielectric layer (200) and before said implantation (700), at least the formation of a protective film (602) on the resin mask (300).

14. Method according to claim 11, wherein said implantation (700) is carried out according to a main direction and by placing the dielectric layer (200) in the presence of a plasma into which is introduced Cx₁Hy₁ where x₁ is the proportion of carbon (C) and y₁ is the proportion of hydrogen (H) and comprising ions heavier than hydrogen; the conditions of the plasma, in particular the concentration of Cx₁Hy₁, the energy of the ions and the main direction of implantation (700) being chosen in such a way that:
- the plasma creates a bombardment of hydrogen-based ions (H, H⁺, H₂⁺, H₃⁺, etc.) from the Cx₁Hy₁ according to the main direction,
- chemical species of the plasma containing carbon from the CxHy form a carbon protective film (601) in particular on surfaces parallel to the direction of the bombardment;
- the plasma creates a bombardment of ions heavier than hydrogen that prevents said chemical species of the plasma containing carbon and from the Cx₁Hy₁ from forming a carbon protective film in particular on the surfaces of the resin mask (300) that are perpendicular to the main direction of the bombardment.

15. Method according to any one of the preceding claims, wherein at least two of the following steps and preferably all the following steps are carried out in a same reactor:
- said first etching,
- said implantation (700),
- said second etching.
